# EUROPÄISCHE PATENTSCHRIFT

(11) **EP 2 814 308 B1**
(45) Veröffentlichungstag und Bekanntmachung des Hinweises auf die Patenterteilung: **26.06.2019**
(21) Anmeldenummer: 13175280.0
(22) Anmeldetag: 05.07.2013
(51) Int. Cl.: H05K 7/14

(54) **3-Level-Stromrichtereinrichtung**
3 level power converter
Dispositif convertisseur de courant à 3 niveaux

(30) Priorität: 10.06.2013 US 201361833359 P
(43) Veröffentlichungstag der Anmeldung: 17.12.2014
(73) Patentinhaber: SEMIKRON Elektronik GmbH & Co. KG, 90431 Nürnberg (DE)
(72) Erfinder: YAMKOVOY, Tatiana, Acton, MA 01720 (US)

(56) Entgegenhaltungen:
- EP-A1- 2 302 782
- EP-A2- 1 101 277
- EP-A2- 1 466 398
- DE-T5-112007 000 366

## Beschreibung

Die Erfindung betrifft eine 3-Level-Stromrichtereinrichtung.

Ein 3-Level-Stromrichter zeichnet sich gegenüber den weit verbreiteten konventionellen Stromrichtern dadurch aus, dass er, wenn er als Wechselrichter betrieben wird, an seinen wechselspannungsseitigen Lastanschlüssen AC nicht nur wie ein konventioneller Stromrichter eine elektrische Wechselspannung erzeugen kann, deren Spannungswert im Wesentlichen der elektrischen positiven oder negativen elektrischen Spannung der Zwischenkreisspannung Ud entspricht, sondern zusätzlich an den wechselspannungsseitigen Lastanschlüssen AC eine elektrische Spannung erzeugen kann, deren Spannungswert im Wesentlichen der halben elektrischen positiven oder negativen Spannung der Zwischenkreisspannung Ud entspricht.

Hierdurch ist z.B. eine bessere Annährung der von Stromrichter an den wechselspannungsseitigen Lastanschlüssen AC erzeugten Spannung an eine sinusförmige Wechselspannung möglich.

Ein 3-Level-Stromrichter weist dabei in der Regel mehrere 3-Level-Stromrichtereinrichtungen auf, die zur Realisierung eines 3-Level Stromrichters elektrisch miteinander verschalten sind.

Die Ausgestaltung der elektrischen Anschlüsse von techniküblichen 3-Level-Stromrichtereinrichtungen, mittels denen technikübliche 3-Level-Stromrichtereinrichtungen, zur Realisierung eines 3-Level Stromrichters, elektrisch leitend miteinander verbunden werden, weist den Nachteil auf, dass diese bei Kommutierungsvorgängen eine relativ hohe wirksame parasitäre Induktivität aufweist, was bei Kommutierungsvorgängen hohe Schaltüberspannungen zur Folge hat, die die realisierbare Schaltgeschwindigkeit und Schaltfrequenz der Leistungshalbleiterschalter der 3-Level-Stromrichtereinrichtungen vermindern.

Aus der EP 1 815 486 B1 ist ein Verbindungsystem zwischen Kondensatorbänken, die mit einem Stromkreis verbunden sind, bekannt.

Aus der EP 2 302 782 A1 ist eine Stromrichteranordnung mit einer Mehrzahl von Stromrichterbaugruppen mit jeweils einer Kühleinrichtung, mindestens einem hierauf angeordneten Leistungshalbleitermodul und mit einer hiermit schaltungsgerecht verbundenen Kondensatoreinrichtung je Stromrichterbaugruppe, bekannt, wobei das mindestens eine Leistungshalbleitermodul zu der Kondensatoreinrichtung eng benachbart angeordnet ist und Gleichstromlastanschlusselemente des Leistungshalbleitermoduls mittels einer flächig ausgebildeten Verschienung mit der Kondensatoreinrichtung verbunden sind.

Aus der DE 11 2007 000 366 T5 ist ein Matrixwandler mit einem Wechselstromkondensator, mit einem IGBT und mit einer Sammelschiene, bekannt, wobei der Wechselstromkondensator über die Sammelschiene mit dem IGBT elektrisch verbunden ist.

Aus der EP 1 466 398 A2 ist ein Wechselrichter mit einem wenigstens teilweise modularen Aufbau, mit lösbar eingebauten Modulen und mit an den Modulen lösbar angebrachten Verbindungsleitungen, bekannt.

Aus der EP 1 101 277 A2 ist eine niederinduktive Verschienung für einen Dreipunkt-Phasenbaustein eines mehrphasigen Dreipunkt-Stromrichters bekannt, wobei für jeden Schalter des Dreipunkt-Phasenbausteins wenigstens ein abschaltbarer Halbleiterschalter vorgesehen ist.

Es ist Aufgabe der Erfindung eine 3-Level-Stromrichtereinrichtung zu schaffen, die niederinduktiv mit einer weiteren 3-Level-Stromrichtereinrichtung elektrisch leitend verbunden werden kann.

Diese Aufgabe wird gelöst durch eine 3-Level-Stromrichtereinrichtung mit Leistungshalbleiterbauelementen, wobei die 3-Level-Stromrichtereinrichtung zur elektrischen Kontaktierung ein erstes Gleichspanungspositivpotentialanschlusselement, ein erstes Gleichspanungsnegativpotentialanschlusselement und ein erstes und ein zweites Neutralspannungspotentialanschlusselement, die jeweilig eine flache Form aufweisen, an einer ersten Seite der 3-Level-Stromrichtereinrichtung angeordnet sind und in einer ersten Raumrichtung in positiver Richtung aus der 3-Level-Stromrichtereinrichtung hervorstehen, aufweist, wobei das erste und das zweite Neutralspannungspotentialanschlusselement elektrisch leitend miteinander verbunden sind, wobei das erste Gleichspanungspositivpotentialanschlusselement und das erste Neutralspannungspotentialanschlusselement ein erstes Anschlusselementpaar, und das zweite Neutralspannungspotentialanschlusselement und das erste Gleichspanungsnegativpotentialanschlusselement ein zweites Anschlusselementpaar bilden, wobei das erste und das zweite Anschlusselementpaar in einer zweiten Raumrichtung nacheinander angeordnet sind, wobei das erste Gleichspanungspositivpotentialanschlusselement und das erste Neutralspannungspotentialanschlusselement in einer dritten Raumrichtung übereinander angeordnet sind, und das zweite Neutralspannungspotentialanschlusselement und das erste Gleichspanungsnegativpotentialanschlusselement in der dritten Raumrichtung übereinander angeordnet sind.

Vorteilhafte Ausbildungen der Erfindung ergeben sich aus den abhängigen Ansprüchen.

Es erweist sich als vorteilhaft, wenn das erste Gleichspanungspositivpotentialanschlusselement und das erste Gleichspanungsnegativpotentialanschlusselement und das erste und das zweite Neutralspannungspotentialanschlusselement parallel zu einer durch die erste und zweite Raumrichtung aufgespannten Ebene verlaufen. Hierdurch wird eine besonders einfache Verbindung der Potentialanschlusselemente mit den Potentialanschlusselementen einer weiteren erfindungsgemäßen 3-Level-Stromrichtereinrichtung ermöglicht.

Weiterhin erweist es sich als vorteilhaft, wenn das zweite Neutralspannungspotentialanschlusselement und das erste Gleichspanungspositivpotentialanschlusselement in der zweiten Raumrichtung nacheinander angeordnet sind, und das erste Gleichspanungsnegativpotentialanschlusselement und das erste Neutralspannungspotentialanschlusselement in der zweiten Raumrichtung nacheinander angeordnet sind. Hierdurch wird eine besonders einfache Verbindung der 3-Level-Stromrichtereinrichtung mit einer weiteren erfindungsgemäßen 3-Level-Stromrichtereinrichtung ermöglicht.

Weiterhin erweist es sich als vorteilhaft, wenn die 3-Level-Stromrichtereinrichtung zur elektrischen Kontaktierung ein zweites Gleichspanungspositivpotentialanschlusselement, ein zweites Gleichspanungsnegativpotentialanschlusselement und ein drittes und ein viertes Neutralspannungspotentialanschlusselement, die jeweilig eine flache Form aufweisen, an einer der ersten Seite gegenüberliegenden zweiten Seite der 3-Level-Stromrichtereinrichtung angeordnet sind und in der ersten Raumrichtung in negativer Richtung aus der 3-Level-Stromrichtereinrichtung hervorstehen, aufweist, wobei das erste, zweite, dritte und das vierte Neutralspannungspotentialanschlusselement elektrisch leitend miteinander verbunden sind, und das erste und das zweite Gleichspanungspositivpotentialanschlusselement elektrisch leitend miteinander verbunden sind, und das erste und das zweite Gleichspanungsnegativpotentialanschlusselement elektrisch leitend miteinander verbunden sind, wobei das zweite Gleichspanungspositivpotentialanschlusselement und das dritte Neutralspannungspotentialanschlusselement eine drittes Anschlusselementpaar, und das vierte Neutralspannungspotentialanschlusselement und das zweite Gleichspanungsnegativpotentialanschlusselement ein viertes Anschlusselementpaar bilden, wobei das dritte und das vierte Anschlusselementpaar in der zweiten Raumrichtung nacheinander angeordnet sind, wobei das zweite Gleichspanungspositivpotentialanschlusselement und das dritte Neutralspannungspotentialanschlusselement in der dritten Raumrichtung übereinander angeordnet sind, und das vierte

Neutralspannungspotentialanschlusselement und das zweite Gleichspanungsnegativpotentialanschlusselement in der dritten Raumrichtung übereinander angeordnet sind. Durch diese Maßnahme wird eine aneinander reihenbare miteinander elektrisch verbindbare 3-Level-Stromrichtereinrichtung geschaffen.

Ferner erweist es sich als vorteilhaft, wenn das zweite Gleichspanungspositivpotentialanschlusselement und das zweite Gleichspanungsnegativpotentialanschlusselement und das dritte und das vierte Neutralspannungspotentialanschlusselement parallel zu einer durch die erste und zweite Raumrichtung aufgespannten Ebene verlaufen. Hierdurch wird eine besonders einfache Verbindung der Potentialanschlusselemente mit den Potentialanschlusselementen einer weiteren erfindungsgemäßen 3-Level-Stromrichtereinrichtung ermöglicht.

Ferner erweist es sich als vorteilhaft, wenn das zweite Gleichspanungsnegativpotentialanschlusselement und das dritte Neutralspannungspotentialanschlusselement in der zweiten Raumrichtung nacheinander angeordnet sind, und das vierte Neutralspannungspotentialanschlusselement und das zweite Gleichspanungspositivpotentialanschlusselement in der zweiten Raumrichtung nacheinander angeordnet sind. Hierdurch wird eine besonders einfache Verbindung der 3-Level-Stromrichtereinrichtung mit einer weiteren erfindungsgemäßen 3-Level-Stromrichtereinrichtung ermöglicht.

Weiterhin erweist es sich ein 3-Level-Stromrichtersystem als vorteilhaft, wobei das 3-Level-Stromrichtersystem eine erste und eine zweite erfindungsgemäß ausgebildete 3-Level-Stromrichtereinrichtung aufweist, wobei
- das erste Gleichspanungspositivpotentialanschlusselement der ersten 3-Level-Stromrichtereinrichtung mit dem zweiten Gleichspanungspositivpotentialanschlusselement der zweiten 3-Level-Stromrichtereinrichtung und
- das erste Gleichspanungsnegativpotentialanschlusselement der ersten 3-Level-Stromrichtereinrichtung mit dem zweiten Gleichspanungsnegativpotentialanschlusselement der zweiten 3-Level-Stromrichtereinrichtung und
- das erste Neutralspannungspotentialanschlusselement der ersten 3-Level-Stromrichtereinrichtung mit dem dritten Neutralspannungspotentialanschlusselement der zweiten 3-Level-Stromrichtereinrichtung und
- das zweite Neutralspannungspotentialanschlusselement der ersten 3-Level-Stromrichtereinrichtung mit dem vierten Neutralspannungspotentialanschlusselement der zweiten 3-Level-Stromrichtereinrichtung elektrisch leitend verbunden ist.

Die erste und zweite erfindungsgemäße 3-Level-Stromrichtereinrichtung sind somit niederinduktiv elektrisch leitend miteinander verbunden.

Weiterhin erweist es sich als vorteilhaft, wenn
- das erste Gleichspanungspositivpotentialanschlusselement der ersten 3-Level-Stromrichtereinrichtung mit dem zweiten Gleichspanungspositivpotentialanschlusselement der zweiten 3-Level-Stromrichtereinrichtung und
- das erste Gleichspanungsnegativpotentialanschlusselement der ersten 3-Level-Stromrichtereinrichtung mit dem zweiten Gleichspanungsnegativpotentialanschlusselement der zweiten 3-Level-Stromrichtereinrichtung und
- das erste Neutralspannungspotentialanschlusselement der ersten 3-Level-Stromrichtereinrichtung mit dem dritten Neutralspannungspotentialanschlusselement der zweiten 3-Level-Stromrichtereinrichtung und
- das zweite Neutralspannungspotentialanschlusselement der ersten 3-Level-Stromrichtereinrichtung mit dem vierten Neutralspannungspotentialanschlusselement der zweiten 3-Level-Stromrichtereinrichtung jeweilig über eine elektrisch leitfähige Klemme verbunden ist.

Hierdurch wird eine einfache Verbindung der 3-Level-Stromrichtereinrichtung mit einer weiteren erfindungsgemäßen 3-Level-Stromrichtereinrichtung ermöglicht.

Ferner erweist es sich als vorteilhaft, wenn die Klemme ein erstes elektrisch leitendes Klemmelement und ein zweites magnetisch nicht leitendes Klemmelement zwischen denen die über die jeweilige Klemme miteinander verbunden jeweiligen Potentialanschlusselemente angeordnet sind, aufweist. Hierdurch werden an der Klemme auftretende Wirbelströme reduziert.

Ferner erweist es sich als vorteilhaft, wenn
- das erste Gleichspanungspositivpotentialanschlusselement der ersten 3-Level-Stromrichtereinrichtung mit dem zweiten Gleichspanungspositivpotentialanschlusselement der zweiten 3-Level-Stromrichtereinrichtung und
- das erste Gleichspanungsnegativpotentialanschlusselement der ersten 3-Level-Stromrichtereinrichtung mit dem zweiten Gleichspanungsnegativpotentialanschlusselement der zweiten 3-Level-Stromrichtereinrichtung und
- das erste Neutralspannungspotentialanschlusselement der ersten 3-Level-Stromrichtereinrichtung mit dem dritten Neutralspannungspotentialanschlusselement der zweiten 3-Level-Stromrichtereinrichtung und
- das zweite Neutralspannungspotentialanschlusselement der ersten 3-Level-Stromrichtereinrichtung mit dem vierten Neutralspannungspotentialanschlusselement der zweiten 3-Level-Stromrichtereinrichtung
   einen elektrisch leitenden Kontakt aufweist und jeweilig mittels einer Schraubverbindung verbunden ist.

Hierdurch wird eine einfache Verbindung der 3-Level-Stromrichtereinrichtung mit einer weiteren erfindungsgemäßen 3-Level-Stromrichtereinrichtung ermöglicht.

Ausführungsbeispiele der Erfindung sind in den Figuren dargestellt und werden im Folgenden näher erläutert. Dabei zeigen:
- FIG 1: ein elektrisches Schaltbild einer techniküblichen 3-Level-Stromrichterhalbbrücke ,
- FIG 2: ein elektrisches Schaltbild einer weiteren techniküblichen 3-Level-Stromrichterhalbbrücke ,
- FIG 3: ein 3-Level-Stromrichtersystem mit drei erfindungsgemäßen 3-Level-Stromrichtereinrichtungen in einer Seitenansicht,
- FIG 4: ein 3-Level-Stromrichtersystem mit drei erfindungsgemäßen 3-Level-Stromrichtereinrichtungen in einer Ansicht von oben auf das 3-Level-Stromrichtersystem,
- FIG 5: eine erste und eine zweite elektrisch leitende Verbindungseinrichtung in einer perspektivischen Ansicht,
- FIG 6: eine erste und eine zweite elektrisch leitende Verbindungseinrichtung in einer Seitenansicht,
- FIG 7: eine Detailansicht von FIG 6 und
- FIG 8: eine weitere erste und zweite elektrisch leitende Verbindungseinrichtung in einer perspektivischen Ansicht.

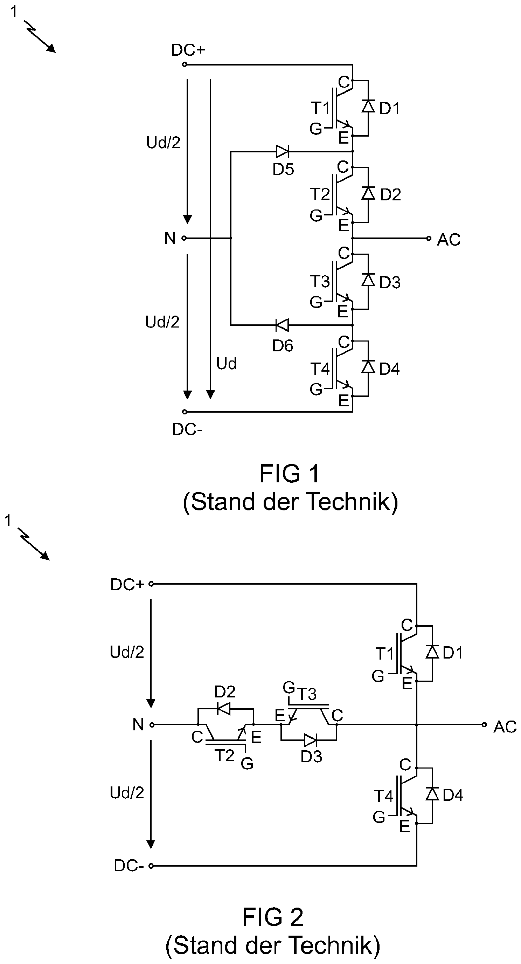

In FIG 1 ist bespielhaft das elektrische Schaltbild einer techniküblichen 3-Level-Stromrichterhalbbrücke 1 dargestellt. Die 3-Level-Stromrichterhalbbrücke 1 weist einen ersten Leistungshalbleiterschalter T1, einen zweiten Leistungshalbleiterschalter T2, einen dritten Leistungshalbleiterschalter T3, einen vierten Leistungshalbleiterschalter T4, erste Diode D1, eine zweite Diode D2, eine dritte Diode D3, eine vierte Diode D4, eine fünfte Diode D5 und eine sechste Diode D6 auf, die elektrisch, wie in FIG 1 dargestellt, die zu der 3-Level- Stromrichterhalbbrücke 1 verschalten sind. Die 3-Level-Stromrichterhalbbrücke wird von zwei in FIG 1 nicht dargestellten Spannungsquellen gespeist, die jeweilig die halbe Zwischenkreisspannung Ud/2 erzeugen, so das zwischen dem Gleichspanungspositivpotentialanschluss DC+ und dem Gleichspanungsnegativpotentialanschluss DC- die Zwischenkreisspannung Ud anliegt, und der Gleichspanungspositivpotentialanschluss DC+ bezogen auf den Neutralspannungspotentialanschluss N die halbe positive Zwischenkreisspannung Ud/2 aufweist, und der Gleichspanungsnegativpotentialanschluss DC- bezogen auf den Neutralspannungspotentialanschluss N die halbe negative Zwischenkreisspannung Ud/2 aufweist. Die 3-Level-Stromrichterhalbbrücke 1 ist solchermaßen als sogenannte NPC-3-Level-Stromrichterhalbbrücke (Neutral Point Clamped) ausgebildet. Der fünften Dioden D5 und der eine sechsten Diode D6 können, was in FIG 1 nicht dargestellt ist, jeweilig Leistungshalbleiterschalter elektrisch antiparallel geschaltet sein. Eine solche 3-Level-Stromrichterhalbbrücke stellt eine spezielle Ausprägung einer NPC-3-Level-Stromrichterhalbbrücke dar und wird fachspezifisch auch als sogenannte ANPC-3-Level-Stromrichterhalbbrücke (Active Neutral Point Clamped) bezeichnet.

In FIG 1 sind die Leistungshalbleiterschalter als IGBT ausgebildet und können über Ihren Steuereingang G ein- und ausgeschaltet werden. Der Kollektoren der Leistungshalbleiterschalter sind mit dem Bezugszeichen C und die Emitter der Leistungshalbleiterschalter sind mit dem Bezugszeichen E versehen. Durch entsprechendes Ein- und Ausgeschalten der Leistungshalbleiterschalter können am wechselspannungsseitigen Lastanschluss AC im Bezug zu einem wechselspannungsseitigen Lastanschluss AC einer in FIG 1 nicht dargestellten weiteren techniküblichen 3-Level-Stromrichterhalbbrücke, die analog wie die in FIG 1 dargestellte 3-Level-Stromrichterhalbbrücke aufgebaut ist, wobei zwischen den beiden wechselspannungsseitigen Lastanschlüssen AC der beiden 3-Level-Stromrichterhalbbrücken eine elektrische Last (z.B. eine Motor) angeordnet ist, elektrische Spannungen erzeugt werden, deren Spannungswerte im Wesentlichen der positiven oder negativen elektrischen Spannung der Zwischenkreisspannung Ud oder im Wesentlichen der positiven oder negativen halben elektrischen Zwischenkreisspannung Ud/2 entsprechen, so dass bei entsprechender Ansteuerung der Leistungshalbleiterschalter eine entsprechende über der Last anliegende Wechselspannung am wechselspannungsseitigen Lastanschluss AC aus der positiven und negativen Zwischenkreisspannung Ud bzw. aus der halben positiven und negativen Zwischenkreisspannung Ud/2 bzw. erzeugt werden kann. Die elektrische Funktionsweise eines 3-Level-Stromrichters ist allgemein bekannter Stand der Technik.

In FIG 2 ist das bespielhaft das elektrische Schaltbild einer weiteren techniküblichen 3-Level-Stromrichterhalbbrücke 1 dargestellt. Die 3-Level-Stromrichterhalbbrücke 1 gemäß FIG 2 entspricht von der Funktionsweise und den Leistungshalbleiterbauelementen der 3-Level-Stromrichterhalbbrücke 1 gemäß FIG 1, weist aber, im Gegensatz zur 3-Level-Stromrichterhalbbrücke 1 gemäß FIG 1, eine sogenannte T-Schaltungstopologie auf. Die 3-Level-Stromrichterhalbbrücke 1 gemäß FIG 2 ist ebenfalls als sogenannte NPC-3-Level-Stromrichterhalbbrücke ausgebildet.

Den Leistungshalbleiterbauelementen können dabei zur Erhöhung der elektrischen Leistung bzw. Stromtragefähigkeit der 3-Level-Stromrichterhalbbrücke jeweilig weitere Leistungshalbleiterbauelemente vom gleichen Typ elektrisch parallel geschaltet sein.

Neben den beiden in FIG 1 und FIG 2 beispielhaft dargestellten elektrischen Schaltungen von 3-Level-Stromrichterhalbbrücken existieren noch weitere technikübliche elektrische Schaltungen von 3-Level-Stromrichterhalbbrücken.

Es sei angemerkt, dass ein 3-Level-Stromrichter mindestens zwei 3-Level-Stromrichterhalbbrücken aufweist. So kann der 3-Level-Stromrichter z.B. drei 3-Level-Stromrichterhalbbrücken aufweisen mittels derer, durch entsprechende Ansteuerung der Leistungshalbleiterschalter der 3-Level-Stromrichterhalbbrücken, eine 3-phasige Wechselspannung, z.B. zur Ansteuerung eines 3-phasigen Elektromotors, erzeugt werden kann. Selbstverständlich kann ein 3-Level-Stromrichter aber auch als Gleichrichter arbeiten.

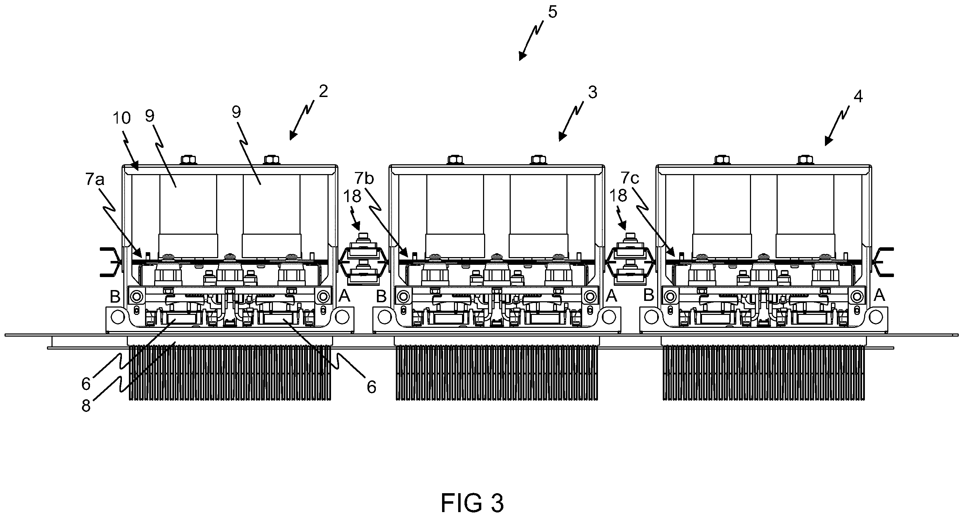

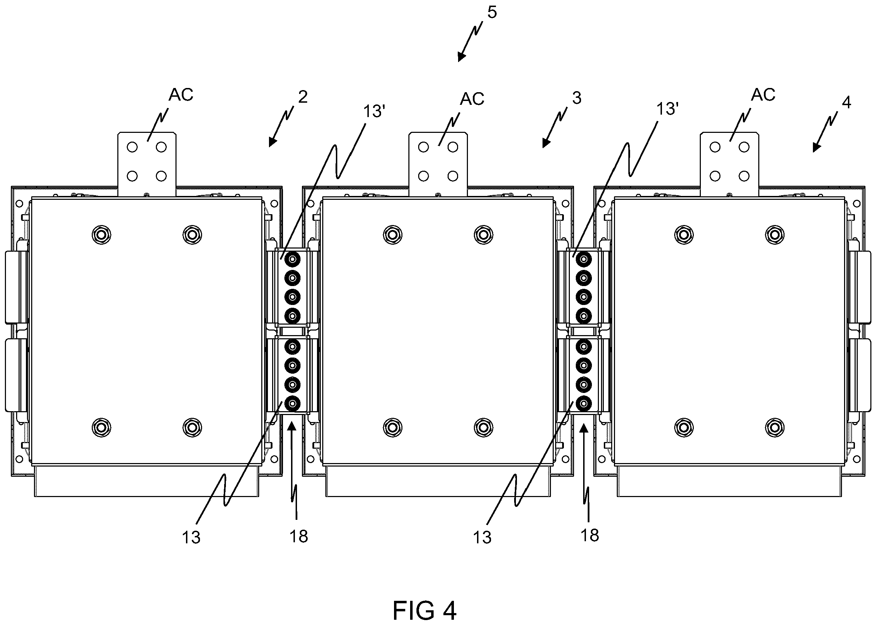

In FIG 3 ist im Rahmen des Ausführungsbeispiels ein 3-Level-Stromrichtersystem 5, das eine erfindungsgemäße erste 3-Level-Stromrichtereinrichtung 2, eine erfindungsgemäße zweite 3-Level-Stromrichtereinrichtung 3 und eine erfindungsgemäße dritte 3-Level-Stromrichtereinrichtung 4 aufweist, in einer Seitenansicht dargestellt. In FIG 4 ist das 3-Level-Stromrichtersystem 5 in einer Ansicht von oben auf das 3-Level-Stromrichtersystem 5 dargestellt. Die erste, zweite und dritte 3-Level-Stromrichtereinrichtung 2, 3 und 4 sind dabei identisch ausgebildet, so dass der Übersichtlichkeit halber überwiegend nur die Elemente der ersten 3-Level-Stromrichtereinrichtung 2 mit einem Bezugszeichen versehen sind und die nachfolgende Beschreibung überwiegend auf die erste 3-Level-Stromrichtereinrichtung 2 bezogen ist aber in identischer Weise auch für die zweite und dritte 3-Level-Stromrichtereinrichtung 3 und 4 gilt.

Die erste 3-Level-Stromrichtereinrichtung 2 weist Leistungshalbleiterbauelemente 6 auf, die jeweilig als Leistungshalbleiterschalter oder als Diode ausgebildet sind. Die Leistungshalbleiterbauelemente 6 sind elektrisch zu einer 3-Level-Stromrichterhalbbrücke verschalten, die z.B. gemäß der in FIG 1 oder FIG 2 dargestellten 3-Level-Stromrichterhalbbrücke 1 ausgebildet sein kann. Die Leistungshalbleiterbauelemente 6 sind vorzugsweise auf einem Substrat angeordnet, das z.B. in Form eines DCB-Substrats (Direct Copper Bonded) oder in Form eines Insulated Metal Substrats vorliegen, kann. Weiterhin weist die erste 3-Level-Stromrichtereinrichtung 2, zur Kühlung der Leistungshalbleiterbauelemente 6, einen Kühlkörper 8 auf, der thermisch leitend an die Leistungshalbleiterbauelemente 6 angekoppelt ist. Weiterhin weist die erste 3-Level-Stromrichtereinrichtung 2 vorzugsweise eine Gehäuse 10 auf, das die Leistungshalbleiterbauelemente 6 abdeckt.

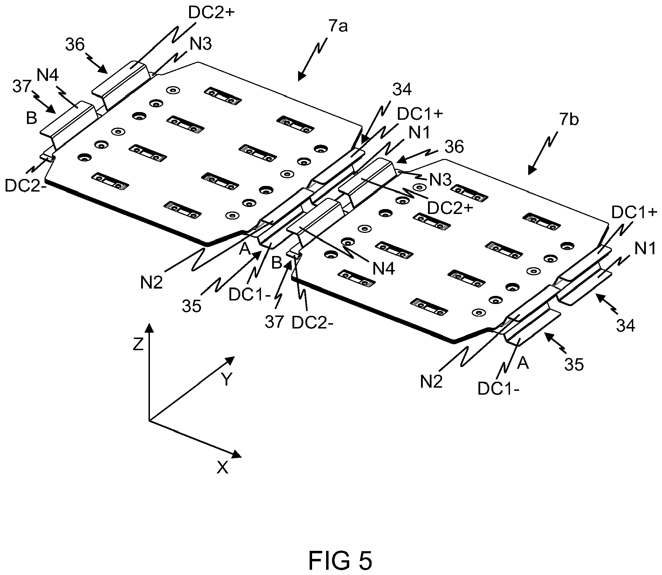

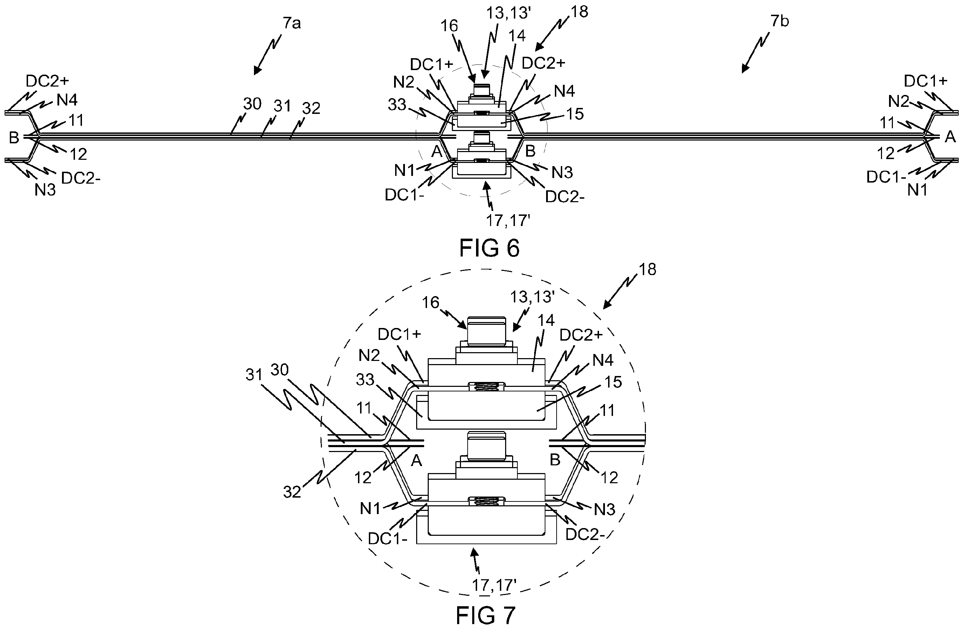

Die erste 3-Level-Stromrichtereinrichtung 2 weist eine elektrisch leitende erste Verbindungseinrichtung 7a und die zweite 3-Level-Stromrichtereinrichtung 3 weist eine elektrisch leitende zweite Verbindungseinrichtung 7b und die dritte 3-Level-Stromrichtereinrichtung 4 weist eine elektrisch leitende dritte Verbindungseinrichtung 7c auf. Die erste, zweite und dritte Verbindungseinrichtung 7a, 7b und 7c sind identisch ausgebildet. Die erste und zweite Verbindungseinrichtung 7a und 7b sind in FIG 5 bis FIG 7 im Detail dargestellt, wobei in FIG 5 die erste und zweite elektrisch leitende Verbindungseinrichtung 7a und 7b in einer perspektivischen Ansicht und in FIG 6 in einer Seitenansicht dargestellt sind. In FIG 7 ist eine Detailansicht von FIG 6 dargestellt.

Die erste 3-Level-Stromrichtereinrichtung 1 weist zur elektrischen Kontaktierung der ersten 3-Level-Stromrichtereinrichtung 1 mit einer externen Einrichtung ein erstes Gleichspanungspositivpotentialanschlusselement DC1+, ein erstes Gleichspanungsnegativpotentialanschlusselement DC1-, ein erstes und ein zweites Neutralspannungspotentialanschlusselement N1 und N2 auf. Die Leistungshalbleiterbauelemente 6 sind mit dem ersten Gleichspanungspositivpotentialanschlusselement DC1+, dem ersten Gleichspanungsnegativpotentialanschlusselement DC1- und dem ersten und dem zweiten Neutralspannungspotentialanschlusselement N1 und N2 elektrisch zu mindestens einer 3-Level-Stromrichterhalbbrücke verschalten. Die externe Einrichtung kann dabei z.B. in Form einer weiteren 3-Level-Stromrichtereinrichtung vorliegen. Das erste Gleichspanungspositivpotentialanschlusselement DC1+, das erste Gleichspanungsnegativpotentialanschlusselement DC1- und das erste und das zweite Neutralspannungspotentialanschlusselement N1 und N2 weisen eine flache Form auf und sind an einer ersten Seite A der ersten 3-Level-Stromrichtereinrichtung 1 angeordnet und stehen in einer ersten Raumrichtung X in positiver Richtung aus der 3-Level-Stromrichtereinrichtung hervor. Das Wechselspannungsanschlusselement AC weist vorzugsweise ebenfalls eine flache Form auf und steht vorzugsweise in einer zweiten Raumrichtung Y aus der 3-Level-Stromrichtereinrichtung 1 hervor. Das erste und das zweite Neutralspannungspotentialanschlusselement N1 und N2 sind elektrisch leitend miteinander verbunden. Das erste Gleichspanungspositivpotentialanschlusselement DC1+ und das erste Neutralspannungspotentialanschlusselement N1 bilden ein erstes Anschlusselementpaar 34, und das zweite Neutralspannungspotentialanschlusselement N2 und das erste Gleichspanungsnegativpotentialanschlusselement DC1- bilden ein zweites Anschlusselementpaar 35, wobei das erste und das zweite Anschlusselementpaar 34 und 35 in der zweiten Raumrichtung Y nacheinander angeordnet sind, wobei das erste Gleichspanungspositivpotentialanschlusselement DC1+ und das erste Neutralspannungspotentialanschlusselement N1 in einer dritten Raumrichtung Z übereinander angeordnet sind, und das zweite Neutralspannungspotentialanschlusselement N2 und das erste Gleichspanungsnegativpotentialanschlusselement DC1- in der dritten Raumrichtung Z übereinander angeordnet sind. Die erste, zweite und dritte Raumrichtung X, Y und Z sind senkrecht zueinander angeordnet.

Das erste Gleichspanungspositivpotentialanschlusselement DC1+ stellt die physikalische Ausbildung des in FIG 1 und FIG 2 im elektrischen Schaltbild dargestellten Gleichspanungspositivpotentialanschluss DC+ dar. Das erste Gleichspanungsnegativpotentialanschlusselement DC1- stellt die physikalische Ausbildung des in FIG 1 und FIG 2 im elektrischen Schaltbild dargestellten Gleichspanungsnegativpotentialanschluss DC- dar. Das erste Neutralspannungspotentialanschlusselement N1 und das zweite Neutralspannungspotentialanschlusselement N2 stellen die physikalische Ausbildung des in FIG 1 und FIG 2 im elektrischen Schaltbild dargestellten Neutralspannungspotentialanschlusses N dar, d.h. der Neutralspannungspotentialanschluss N wird erfindungsgemäß physikalisch in Form der zwei elektrisch leitend miteinander verbundenen Neutralspannungspotentialanschlusselementen N1 und N2 ausgebildet.

Das Wechselspannungsanschlusselement AC stellt die physikalische Ausbildung des in FIG 1 und FIG 2 im elektrischen Schaltbild dargestellten wechselspannungsseitigen Lastanschlusses AC dar.

Beim allgemeinen Betrieb einer 3-Level-Stromrichterhalbbrücke sind die beim Ein- und Ausschalten der Leistungshalbleiterschalter 6 sich ausbildenden Kommutierungskreise der elektrischen Ströme zwischen dem Gleichspanungspositivpotentialanschluss DC+ und dem Neutralspannungspotentialanschluss N, und zwischen dem Gleichspanungsnegativpotentialanschluss DC- und dem Neutralspannungspotentialanschluss N angeordnet. Diese technische Erkenntnis wird zur Realisierung der erfindungsgemäßen 3-Level-Stromrichtereinrichtung 1, die niederinduktiv mit einer weiteren 3-Level-Stromrichtereinrichtung elektrisch leitend verbunden werden kann, verwendet, indem der in FIG 1 und FIG 2 im elektrischen Schaltbild dargestellten Neutralspannungspotentialanschluss N physikalisch in Form der ersten und der zweiten elektrisch leitend miteinander verbundenen Neutralspannungspotentialanschlusselemente N1 und N2 realisiert ist und dem ersten Gleichspanungspositivpotentialanschlusselement DC1+ das erste Neutralspannungspotentialanschlusselemente N1 und dem ersten Gleichspanungsnegativpotentialanschlusselement DC1- das zweite Neutralspannungspotentialanschlusselemente N2 zugeordnet ist. Jeder der Gleichspanungspotentialanschlusselemente hat somit ein dem jeweiligen Gleichspanungspotentialanschlusselement zugeordnetes Neutralspannungspotentialanschlusselement.

Im Rahmen des Ausführungsbeispiels verlaufen das erste Gleichspanungspositivpotentialanschlusselement DC+ und das erste Gleichspanungsnegativpotentialanschlusselement DC- und das erste und das zweite Neutralspannungspotentialanschlusselement N1 und N2 parallel zu einer durch die erste und zweite Raumrichtung X und Y aufgespannten Ebene.

Vorzugsweise sind das zweite Neutralspannungspotentialanschlusselement N2 und das erste Gleichspanungspositivpotentialanschlusselement DC1+ in der zweiten Raumrichtung Y nacheinander angeordnet, und das erste Gleichspanungsnegativpotentialanschlusselement DC1- und das erste Neutralspannungspotentialanschlusselement N1 in der zweiten Raumrichtung Y nacheinander angeordnet. Das zweite Neutralspannungspotentialanschlusselement N2 ist somit vorzugsweise gegenüber dem ersten Neutralspannungspotentialanschlusselement N1 im Bezug zur ersten Raumrichtung X (Drehachse) um 180° gedreht und in Richtung der zweiten Raumrichtung Y verschoben angeordnet.

Bei Ausführungsbeispiel weist die 3-Level-Stromrichtereinrichtung 1 zur elektrischen Kontaktierung der 3-Level-Stromrichtereinrichtung 1 ein zweites Gleichspanungspositivpotentialanschlusselement DC2+, ein zweites Gleichspanungsnegativpotentialanschlusselement DC2- und ein drittes und ein viertes Neutralspannungspotentialanschlusselement N3 und N4, die jeweilig eine flache Form aufweisen, an einer der ersten Seite A gegenüberliegenden zweiten Seite B der 3-Level-Stromrichtereinrichtung 1 angeordnet sind und in einer ersten Raumrichtung X in negativer Richtung aus der 3-Level-Stromrichtereinrichtung1 hervorstehen, auf. Das erste, zweite, dritte und das vierte Neutralspannungspotentialanschlusselement N1, N2, N3 und N4 sind elektrisch leitend miteinander verbunden. Weiterhin sind das erste und das zweite Gleichspanungspositivpotentialanschlusselement DC1+ und DC2+ elektrisch leitend miteinander verbunden und das erste und das zweite Gleichspanungsnegativpotentialanschlusselement DC1- und DC2- elektrisch leitend miteinander verbunden. Das zweite Gleichspanungspositivpotentialanschlusselement DC2+ und das dritte Neutralspannungspotentialanschlusselement N3 bilden ein drittes Anschlusselementpaar 36, und das vierte Neutralspannungspotentialanschlusselement N4 und das zweite Gleichspanungsnegativpotentialanschlusselement DC2- bilden ein viertes Anschlusselementpaar 37, wobei das dritte und das vierte Anschlusselementpaar 36 und 37 in der zweiten Raumrichtung Y nacheinander angeordnet sind, wobei das zweite Gleichspanungspositivpotentialanschlusselement DC2+ und das dritte Neutralspannungspotentialanschlusselement N3 in der dritten Raumrichtung Z übereinander angeordnet sind, und das vierte Neutralspannungspotentialanschlusselement N4 und das zweite Gleichspanungsnegativpotentialanschlusselement DC2- in der dritten Raumrichtung Z übereinander angeordnet sind.

Das erste und das zweite Gleichspanungspositivpotentialanschlusselement DC1+ und DC2+ stellt die physikalische Ausbildung des in FIG 1 und FIG 2 im elektrischen Schaltbild dargestellten Gleichspanungspositivpotentialanschluss DC+ dar. Das erste und zweite Gleichspanungsnegativpotentialanschlusselement DC1- und DC2- stellt die physikalische Ausbildung des in FIG 1 und FIG 2 im elektrischen Schaltbild dargestellten Gleichspanungsnegativpotentialanschluss DC- dar. Das erste Neutralspannungspotentialanschlusselement N1 und das zweite Neutralspannungspotentialanschlusselement N2 und das dritte Neutralspannungspotentialanschlusselement N3 und das vierte Neutralspannungspotentialanschlusselement N4 stellen die physikalische Ausbildung des in FIG 1 und FIG 2 im elektrischen Schaltbild dargestellten Neutralspannungspotentialanschluss N dar, d.h. der Neutralspannungspotentialanschluss N wird physikalisch in Form der vier elektrisch leitend miteinander verbundenen Neutralspannungspotentialanschlusselementen N1, N2, N3 und N4 ausgebildet. Durch diese Maßnahme wird eine aneinander reihenbare miteinander elektrisch verbindbare 3-Level-Stromrichtereinrichtung geschaffen.

Im Rahmen des Ausführungsbeispiels verlaufen das zweite Gleichspanungspositivpotentialanschlusselement DC2+ und das zweite Gleichspanungsnegativpotentialanschlusselement DC2- und das dritte und das vierte Neutralspannungspotentialanschlusselement N3 und N4 parallel zu einer durch die erste und zweite Raumrichtung aufgespannten Ebene.

Vorzugsweise sind das zweite Gleichspanungsnegativpotentialanschlusselement DC2- und das dritte Neutralspannungspotentialanschlusselement N3 in der zweiten Raumrichtung Y nacheinander angeordnet, und das vierte Neutralspannungspotentialanschlusselement N4 und das zweite Gleichspanungspositivpotentialanschlusselement DC2+ in der zweiten Raumrichtung Y nacheinander angeordnet. Das dritte Neutralspannungspotentialanschlusselement N3 ist somit vorzugsweise gegenüber dem vierten Neutralspannungspotentialanschlusselement N4 im Bezug zur ersten Raumrichtung X (Drehachse) um 180° gedreht und in Richtung der zweiten Raumrichtung Y verschoben angeordnet.

Das zweite Gleichspanungspositivpotentialanschlusselement DC2+ ist vorzugsweise in Bezug auf eine durch die zweite und dritte Raumrichtung Y und Z aufgespannte Ebene spiegelbildlich zum ersten Gleichspanungspositivpotentialanschlusselement DC1+ angeordnet, wobei die Abmessungen des ersten und zweiten Gleichspanungspositivpotentialanschlusselements DC1+ und DC2+ sich voneinander unterscheiden können.

Das zweite Gleichspanungsnegativpotentialanschlusselement DC2- ist vorzugsweise in Bezug auf eine durch die zweite und dritte Raumrichtung Y und Z aufgespannte Ebene spiegelbildlich zum ersten Gleichspanungsnegativpotentialanschlusselement DC1- angeordnet, wobei die Abmessungen des ersten und zweiten Gleichspanungsnegativpotentialanschlusselements DC1- und DC2- sich voneinander unterscheiden können.

Das dritte Neutralspannungspotentialanschlusselement N3 ist vorzugsweise in Bezug auf eine durch die zweite und dritte Raumrichtung Y und Z aufgespannte Ebene spiegelbildlich zum ersten Neutralspannungspotentialanschlusselement N1 angeordnet, wobei die Abmessungen des ersten und dritten Neutralspannungspotentialanschlusselements N1 und N3 sich voneinander unterscheiden können.

Das vierte Neutralspannungspotentialanschlusselement N4 ist vorzugsweise in Bezug auf eine durch die zweite und dritte Raumrichtung Y und Z aufgespannte Ebene spiegelbildlich zum zweiten Neutralspannungspotentialanschlusselement N2 angeordnet, wobei die Abmessungen des zweiten und vierten Neutralspannungspotentialanschlusselements N2 und N4 sich voneinander unterscheiden können.

Im Rahmen des Ausführungsbeispiels liegen das erste und zweite Gleichspanungspositivpotentialanschlusselement DC1+ und DC2+ in Richtung der ersten Raumrichtung X verlaufenden Endabschnitte eines mehrfachabgewinkelten elektrisch leitenden ersten Metallblechelements 30 vor, und das erste, zweite, dritte und vierte Neutralspannungspotentialanschlusselements N1,N2, N3 und N4 in Richtung der ersten Raumrichtung X verlaufenden Endabschnitte eines mehrfachabgewinkelten elektrisch leitenden zweiten Metallblechelements 31 vor, und das erste und zweite Gleichspanungsnegativpotentialanschlusselement DC1- und DC2- in Richtung der ersten Raumrichtung X verlaufenden Endabschnitte eines mehrfachabgewinkelten elektrisch leitenden dritten Metallblechelements 32 vor. Das erste, zweite und dritte Metallblechelement 30, 31 und 32 kann z.B. aus Kupfer bestehen, das z.B. mit einer oder mehreren metallischen Oberflächenbeschichtungen versehen sein kann. Zwischen einem jeweiligen Mittenabschnitt des ersten und zweiten Metallblechelements 30 und 31 ist eine elektrisch nicht leitende erste Schicht 11 (z.B. Kunststofffolie) angeordnet, die das erste und zweite Metallblechelement 30 und 31 elektrisch voneinander isoliert. Zwischen einem jeweiligen Mittenabschnitt des zweiten und dritten Metallblechelements 31 und 32 ist eine elektrisch nicht leitende zweite Schicht 12 (z.B. Kunststofffolie) angeordnet, die das zweite und dritte Metallblechelement 31 und 32 elektrisch voneinander isoliert. Das erste, zweite und dritte Metallblechelement 30, 31 und 32 bilden zusammen mit der elektrisch nicht leitende ersten und zweiten Schicht 11 und 12 die erste elektrisch leitende Verbindungseinrichtung 7a aus. Durch die eng beanstandete Anordnung des ersten, zweiten und dritten Metallblechelement 30, 31 und 32 weist die Verbindungseinrichtung 7a nur eine sehr geringe Induktivität auf. Die zweite und dritte elektrisch leitende Verbindungseinrichtung 7b und 7c sind identisch wie die Verbindungseinrichtung 7a ausgebildet.

Weiterhin weist die erste 3-Level-Stromrichtereinrichtung 2 vorzugsweise Zwischenkreiskondensatoren 9 auf, wobei ein jeweiliger Zwischenkreiskondensator der Zwischenkreiskondensatoren 9 elektrisch leitend mit zwei der drei Metallblechelemente verbunden ist.

Wie in FIG 3, FIG 4, FI6 und FIG 7 dargestellt können mittels dem ersten und zweiten Gleichspanungspositivpotentialanschlusselement DC1+ und DC2+ und dem ersten und zweiten Gleichspanungsnegativpotentialanschlusselement DC1- und DC2- und dem ersten, zweiten, dritten und vierten Neutralspannungspotentialanschlusselement N1, N2, N3 und N4 mehrere erfindungsgemäße 3-Level-Stromrichtereinrichtungen zu einem 3-Level-Stromrichtersystem elektrisch leitend miteinander verbunden werden. Beim Ausführungsbeispiel werden solchermaßen die erste 3-Level-Stromrichtereinrichtung 2, die zweite 3-Level-Stromrichtereinrichtung 3 und die dritte 3-Level-Stromrichtereinrichtung 4 elektrisch leitend zu dem 3-Level-Stromrichtersystem 5 miteinander verbunden. Die jeweilige Verbindung zwischen den 3-Level-Stromrichtereinrichtungen ist in den Figuren mit dem Bezugszeichen 18 versehen. Es sei dabei angemerkt, dass selbstverständlich noch mehr 3-Level-Stromrichtereinrichtungen als die im Ausführungsbeispiel vorhandenen drei 3-Level-Stromrichtereinrichtungen 2, 3 und 4 zu einem 3-Level-Stromrichtersystem in identischer Weise elektrisch leitend miteinander verbunden werden können.

Wie in FIG4, FIG 6 und FIG 7 dargestellt ist zur elektrischen Verbindung der ersten 3-Level-Stromrichtereinrichtung 2 mit der zweiten 3-Level-Stromrichtereinrichtung 3 das erste Gleichspanungspositivpotentialanschlusselement DC1+ der ersten 3-Level-Stromrichtereinrichtung 2 mit dem zweiten Gleichspanungspositivpotentialanschlusselement DC2+ der zweiten 3-Level-Stromrichtereinrichtung 3 und das erste Gleichspanungsnegativpotentialanschlusselement DC1- der ersten 3-Level-Stromrichtereinrichtung 2 mit dem zweiten Gleichspanungsnegativpotentialanschlusselement DC2- der zweiten 3-Level-Stromrichtereinrichtung 3 und das erste Neutralspannungspotentialanschlusselement N1 der ersten 3-Level-Stromrichtereinrichtung 2 mit dem dritten Neutralspannungspotentialanschlusselement N3 der zweiten 3-Level-Stromrichtereinrichtung 3 und das zweite Neutralspannungspotentialanschlusselement N2 der ersten 3-Level-Stromrichtereinrichtung 2 mit dem vierten Neutralspannungspotentialanschlusselement N4 der zweiten 3-Level-Stromrichtereinrichtung 3 elektrisch leitend verbunden. Die dritte 3-Level-Stromrichtereinrichtung 4 ist mit der zweiten 3-Level-Stromrichtereinrichtung 3 in identischer Weise verbunden.

Im Rahmen des Ausführungsbeispiels gemäß der Figuren 3, 4, 6 und 7 ist das erste Gleichspanungspositivpotentialanschlusselement DC1+ der ersten 3-Level-Stromrichtereinrichtung 2 mit dem zweiten Gleichspanungspositivpotentialanschlusselement DC2+ der zweiten 3-Level-Stromrichtereinrichtung 3 und das erste Gleichspanungsnegativpotentialanschlusselement DC1- der ersten 3-Level-Stromrichtereinrichtung 2 mit dem zweiten Gleichspanungsnegativpotentialanschlusselement DC2- der zweiten 3-Level-Stromrichtereinrichtung 3 und das erste Neutralspannungspotentialanschlusselement N1 der ersten 3-Level-Stromrichtereinrichtung 2 mit dem dritten Neutralspannungspotentialanschlusselement N3 der zweiten 3-Level-Stromrichtereinrichtung 3 und das zweite Neutralspannungspotentialanschlusselement N2 der ersten 3-Level-Stromrichtereinrichtung 2 mit dem vierten Neutralspannungspotentialanschlusselement N4 der zweiten 3-Level-Stromrichtereinrichtung 3 jeweilig über eine elektrisch leitfähige Klemme 13, 13', 17 bzw. 17' verbunden. Die dritte 3-Level-Stromrichtereinrichtung 4 ist mit der zweiten 3-Level-Stromrichtereinrichtung 3 in identischer Weise verbunden.

Vorzugsweise weist die elektrisch leitfähige Klemme 13, 13', 17 bzw. 17' ein erstes elektrisch leitendes Klemmelement 14 (z.B. aus Kupfer, wobei das Kupfer mit einer Oberflächenbeschichtung versehen sein kann) und ein zweites magnetisch nicht leitendes Klemmelement 15 (z.B. aus Edelstahl) zwischen denen die über die jeweilige Klemme (13,13',17,17') miteinander verbunden jeweiligen Potentialanschlusselemente angeordnet sind, auf. Die erste und zweite Klemmelement 14 und 15 werden dabei mittels einer Schraubverbindung 16, welche das erste und das zweite Klemmelement 14 und 15 miteinander verbindet, gegeneinander gedrückt, wobei die beiden zu verbinden jeweiligen Potentialanschlusselemente zwischen dem ersten und zweiten Klemmelement 14 und 15 angeordnet sind. Dadurch, dass das Klemmelement 15 aus einem magnetisch nicht leitenden Material besteht, werden an der Klemme auftretende Wirbelströme reduziert. Die Klemmen weisen an ihrer Unterseite einen elektrisch nicht leitenden Isolationskörper 33 (z.B. aus Kunststoff) auf, der die Klemmen 17 und 17' von den darüber angeordneten Klemmen 13 und 13' elektrisch isoliert.

Alternativ zu der in den Figuren dargestellten und oben beschrieben Klemme, kann als Klemme auch die in der EP 1 815 486 B1 offenbarte bipolare Klemme, mit der mittels einer einzelnen Klemme jeweils zwei unterschiedliche elektrische Potential aufweisende Verbindungen hergestellt werden können, verwendet werden und somit die Anzahl der benötigten Klemmen um die Hälfte reduziert werden.

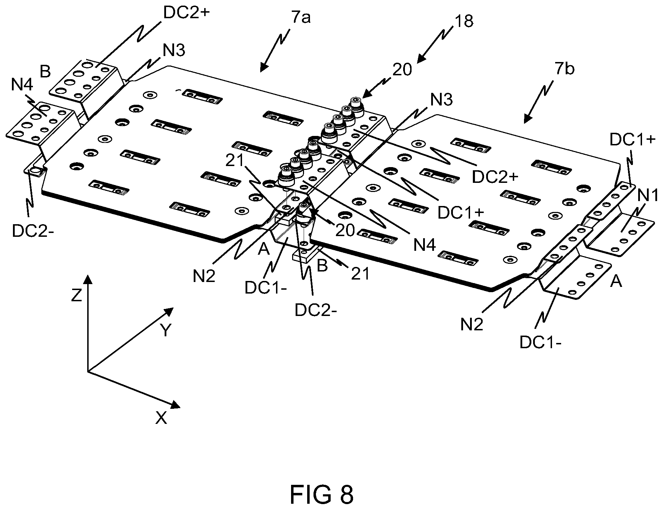

Alternativ können, wie in FIG 8 anhand der ersten und zweiten Verbindungseinrichtung 7a und 7b dargestellt, mehrere erfindungsgemäße 3-Level-Stromrichtereinrichtung auch direkt miteinander mittels einer Schraubverbindung elektrisch leitend verbunden werden. Das erste Gleichspanungspositivpotentialanschlusselement DC1+ der ersten 3-Level-Stromrichtereinrichtung 2 weist mit dem zweiten Gleichspanungspositivpotentialanschlusselement DC2+ der zweiten 3-Level-Stromrichtereinrichtung 3 und das erste Gleichspanungsnegativpotentialanschlusselement DC1- der ersten 3-Level-Stromrichtereinrichtung 2 weist mit dem zweiten Gleichspanungsnegativpotentialanschlusselement DC2- der zweiten 3-Level-Stromrichtereinrichtung 3 und das erste Neutralspannungspotentialanschlusselement N1 der ersten 3-Level-Stromrichtereinrichtung 2 weist mit dem dritten Neutralspannungspotentialanschlusselement N3 der zweiten 3-Level-Stromrichtereinrichtung 3 und das zweite Neutralspannungspotentialanschlusselement N2 der ersten 3-Level-Stromrichtereinrichtung 2 weist mit dem vierten Neutralspannungspotentialanschlusselement N4 der zweiten 3-Level-Stromrichtereinrichtung 3 einen elektrisch leitenden Kontakt auf und ist mit dem jeweiligen Potentialanschlusselement mittels einer Schraubverbindung 20 verbunden. Die Potentialanschlusselemente weisen hierzu vorzugsweise, wie in FIG 8 dargestellt, Durchgangslöcher auf durch die, zur Realisierung der Schraubverbindung, Schrauben hindurchreichen, wobei die Schrauben in mit einem Gewinde versehende Löcher eines jeweilig zugeordneten Gegenschraubelements 21 geschraubt sind.

Im Rahmen des Ausführungsbeispiels weist dabei das zweite Neutralspannungspotentialanschlusselement N2, das erste Gleichspanungspositivpotentialanschlusselement DC1+, das zweite Gleichspanungsnegativpotentialanschlusselement DC2- und das dritte Neutralspannungspotentialanschlusselement N3 gegenüber dem ersten Gleichspanungsnegativpotentialanschlusselement DC1-, dem ersten Neutralspannungspotentialanschlusselement N1, dem vierten Neutralspannungspotentialanschlusselement N4 und dem zweiten Gleichspanungspositivpotentialanschlusselement DC2+ in der ersten Raumrichtung X eine geringere Ausdehnung auf. Alternativ hierzu könnte auch das erste Gleichspanungsnegativpotentialanschlusselement DC1-, das erste Neutralspannungspotentialanschlusselement N1, das vierte Neutralspannungspotentialanschlusselement N4 und das zweite Gleichspanungspositivpotentialanschlusselement DC2+ gegenüber dem zweiten Neutralspannungspotentialanschlusselement N2, dem ersten Gleichspanungspositivpotentialanschlusselement DC1+, dem zweiten Gleichspanungsnegativpotentialanschlusselement DC2- und dem dritten Neutralspannungspotentialanschlusselement N3 in der ersten Raumrichtung X eine geringere Ausdehnung aufweisen. Hierdurch wird eine einfache Anordnung der Potentialanschlusselemente, die miteinander verschraubt werden sollen ermöglicht.

Ansonsten entspricht das Ausführungsbeispiel gemäß FIG 8 dem Ausführungsbeispiel gemäß FIG 5.

Die Leistungshalbleiterschalter liegen im Allgemeinen in Form von Transistoren, wie z.B. IGBTs (Insulated Gate Bipolar Transistor) oder MOSFETs (Metal Oxide Semiconductor Field Effect Transistor), oder in Form von gesteuert ausschaltbaren Thyristoren vor, wobei im Rahmen des Ausführungsbeispiels die Leistungshalbleiterschalter in Form von IGBTs vorliegen und der erste Laststromanschluss C des jeweiligen Leistungshalbleiterschalters in Form des Kollektors des jeweiligen IGBT und der zweite Laststromanschluss E des jeweiligen Leistungshalbleiterschalters in Form des Emitters des jeweiligen IGBT vorliegt. Der Steueranschluss der Leistungshalbleiterschalter liegt beim Ausführungsbeispiel in Form des Gate G des jeweiligen IGBT vor.

Es sei an dieser Stelle angemerkt, dass die erfindungsgemäße 3-Level-Stromrichtereinrichtung selbstverständlich auch mehrere 3-Level-Stromrichterhalbbrücken aufweisen kann.

Weiterhin sei an dieser Stelle angemerkt, dass im Sinne der vorliegenden Erfindung unter dem Ausdruck, dass zwei Elemente elektrisch leitend verbunden sind bzw. miteinander elektrisch leitend verbunden werden, sowohl eine direkte elektrisch leitende Verbindung von zwei Elementen, mittels z.B. einer Schweiß-, Löt- oder Sinterverbindung, die zwischen den beiden Elementen besteht, als auch eine indirekte elektrisch leitende Verbindung, mittels z.B. einem oder mehreren elektrisch leitenden Leitungselementen, wie z.B. einer Leiterbahn, einem Bonddraht, einem elektrisch leitenden Folienverbund, einer Stromschiene, oder einem Kabel, die die beiden Elemente elektrisch miteinander verbinden, so dass eine bidirektionaler elektrischer Stromfluss zwischen den beiden elektrisch miteinander leitend verbunden Elementen möglich ist, verstanden wird.

Weiterhin sei angemerkt, dass im Sinne der vorliegenden Erfindung unter dem allgemeineren Ausdruck Potentialanschlusselement ein Gleichspanungspositivpotentialanschlusselement, ein Gleichspanungsnegativpotentialanschlusselement oder ein Neutralspannungspotentialanschlusselement verstanden wird.

## Patentansprüche

1. 3-Level-Stromrichtereinrichtung mit Leistungshalbleiterbauelementen (6), wobei die 3-Level-Stromrichtereinrichtung (2,3,4) zur elektrischen Kontaktierung ein erstes Gleichspannungspositivpotentialanschlusselement (DC1+), ein erstes Gleichspannungsnegativpotentialanschlusselement (DC1-) und ein erstes und ein zweites Neutralspannungspotentialanschlusselement (N1,N2), die jeweilig eine flache Form aufweisen, an einer ersten Seite (A) der 3-Level-Stromrichtereinrichtung (2,3,4) angeordnet sind und in einer ersten Raumrichtung (X) in positiver Richtung aus der 3-Level-Stromrichtereinrichtung (2,3,4) hervorstehen, aufweist, wobei das erste und das zweite Neutralspannungspotentialanschlusselement (N2,N2) elektrisch leitend miteinander verbunden sind, wobei das erste Gleichspannungspositivpotentialanschlusselement (DC1+) und das erste Neutralspannungspotentialanschlusselement (N1) ein erstes Anschlusselementpaar (34), und das zweite Neutralspannungspotentialanschlusselement (N2) und das erste Gleichspannungsnegativpotentialanschlusselement (DC1-) ein zweites Anschlusselementpaar (35) bilden, wobei das erste und das zweite Anschlusselementpaar (34,35) in einer zweiten Raumrichtung (Y) nacheinander angeordnet sind, wobei das erste Gleichspannungspositivpotentialanschlusselement (DC1+) und das erste Neutralspannungspotentialanschlusselement (N1) in einer dritten Raumrichtung (Z) übereinander angeordnet sind, und das zweite Neutralspannungspotentialanschlusselement (N2) und das erste Gleichspannungsnegativpotentialanschlusselement (DC1-) in der dritten Raumrichtung (Z) übereinander angeordnet sind.

2. 3-Level-Stromrichtereinrichtung nach Anspruch 1, **dadurch gekennzeichnet, dass** das erste Gleichspannungspositivpotentialanschlusselement (DC1+) und das erste Gleichspannungsnegativpotentialanschlusselement (DC1-) und das erste und das zweite Neutralspannungspotentialanschlusselement (N1,N2) parallel zu einer durch die erste und zweite Raumrichtung (X,Y) aufgespannten Ebene verlaufen.

3. 3-Level-Stromrichtereinrichtung nach einem der vorhergehenden Ansprüche, **dadurch gekennzeichnet, dass** das zweite Neutralspannungspotentialanschlusselement (N2) und das erste Gleichspannungspositivpotentialanschlusselement (DC1+) in der zweiten Raumrichtung (Y) nacheinander angeordnet sind, und das erste Gleichspannungsnegativpotentialanschlusselement (DC1-) und das erste Neutralspannungspotentialanschlusselement (N1) in der zweiten Raumrichtung (Y) nacheinander angeordnet sind.

4. 3-Level-Stromrichtereinrichtung nach einem der vorhergehenden Ansprüche, **dadurch gekennzeichnet, dass** der 3-Level-Stromrichtereinrichtung (2,3,4) zur elektrischen Kontaktierung ein zweites Gleichspannungspositivpotentialanschlusselement (DC2+), ein zweites Gleichspannungsnegativpotentialanschlusselement (DC2-) und ein drittes und ein viertes Neutralspannungspotentialanschlusselement (N3,N4), die jeweilig eine flache Form aufweisen, an einer der ersten Seite (A) gegenüberliegenden zweiten Seite (B) der 3-Level-Stromrichtereinrichtung (2,3,4) angeordnet sind und in der ersten Raumrichtung (X) in negativer Richtung aus der 3-Level-Stromrichtereinrichtung (2,3,4) hervorstehen, aufweist, wobei das erste, zweite, dritte und das vierte Neutralspannungspotentialanschlusselement (N1,N2,N3,N4) elektrisch leitend miteinander verbunden sind, und das erste und das zweite Gleichspannungspositivpotentialanschlusselement (DC1+,DC2+) elektrisch leitend miteinander verbunden sind, und das erste und das zweite Gleichspannungsnegativpotentialanschlusselement (DC1-,DC2-) elektrisch leitend miteinander verbunden sind, wobei das zweite Gleichspannungspositivpotentialanschlusselement (DC2+) und das dritte Neutralspannungspotentialanschlusselement (N3) eine drittes Anschlusselementpaar (36), und das vierte Neutralspannungspotentialanschlusselement (N4) und das zweite Gleichspannungsnegativpotentialanschlusselement (DC2-) ein viertes Anschlusselementpaar (37) bilden, wobei das dritte und das vierte Anschlusselementpaar (36,37) in der zweiten Raumrichtung (Y) nacheinander angeordnet sind, wobei das zweite Gleichspannungspositivpotentialanschlusselement (DC2+) und das dritte Neutralspannungspotentialanschlusselement (N3) in der dritten Raumrichtung (Z) übereinander angeordnet sind, und das vierte Neutralspannungspotentialanschlusselement (N4) und das zweite Gleichspannungsnegativpotentialanschlusselement (DC2-) in der dritten Raumrichtung (Z) übereinander angeordnet sind.

5. 3-Level-Stromrichtereinrichtung nach Anspruch 4, **dadurch gekennzeichnet, dass** das zweite Gleichspannungspositivpotentialanschlusselement (DC2+) und das zweite Gleichspannungsnegativpotentialanschlusselement (DC2-) und das dritte und das vierte Neutralspannungspotentialanschlusselement (N3,N4) parallel zu einer durch die erste und zweite Raumrichtung (X,Y) aufgespannten Ebene verlaufen.

6. 3-Level-Stromrichtereinrichtung nach Anspruch 4 oder 5,
**dadurch gekennzeichnet, dass** das zweite Gleichspannungsnegativpotentialanschlusselement (DC2-) und das dritte Neutralspannungspotentialanschlusselement (N3) in der zweiten Raumrichtung (Y) nacheinander angeordnet sind, und das vierte Neutralspannungspotentialanschlusselement (N4) und
das zweite Gleichspannungspositivpotentialanschlusselement (DC2+) in der zweiten Raumrichtung (Y) nacheinander angeordnet sind.

7. 3-Level-Stromrichtersystem, wobei das 3-Level-Stromrichtersystem (5) eine erste und eine zweite nach einem der Ansprüche 4 bis 6 ausgebildete 3-Level-Stromrichtereinrichtung (2,3) aufweist, wobei
- das erste Gleichspannungspositivpotentialanschlusselement (DC1+) der ersten 3-Level-Stromrichtereinrichtung (2) mit dem zweiten Gleichspannungspositivpotentialanschlusselement (DC2+) der zweiten 3-Level-Stromrichtereinrichtung (3) und
- das erste Gleichspannungsnegativpotentialanschlusselement (DC1-) der ersten 3-Level-Stromrichtereinrichtung (2) mit dem zweiten Gleichspannungsnegativpotentialanschlusselement (DC2-) der zweiten 3-Level-Stromrichtereinrichtung (3) und
- das erste Neutralspannungspotentialanschlusselement (N1) der ersten 3-Level-Stromrichtereinrichtung (2) mit dem dritten Neutralspannungspotentialanschlusselement (N3) der zweiten 3-Level-Stromrichtereinrichtung (3) und
- das zweite Neutralspannungspotentialanschlusselement (N2) der ersten 3-Level-Stromrichtereinrichtung (2) mit dem vierten Neutralspannungspotentialanschlusselement (N4) der zweiten 3-Level-Stromrichtereinrichtung (3) elektrisch leitend verbunden ist.

8. 3-Level-Stromrichtersystem nach Anspruch 7, **dadurch gekennzeichnet, dass**
- das erste Gleichspannungspositivpotentialanschlusselement (DC1+) der ersten 3-Level-Stromrichtereinrichtung (2) mit dem zweiten Gleichspannungspositivpotentialanschlusselement (DC2+) der zweiten 3-Level-Stromrichtereinrichtung (3) und
- das erste Gleichspannungsnegativpotentialanschlusselement (DC1-) der ersten 3-Level-Stromrichtereinrichtung (2) mit dem zweiten Gleichspannungsnegativpotentialanschlusselement (DC2-) der zweiten 3-Level-Stromrichtereinrichtung (3) und
- das erste Neutralspannungspotentialanschlusselement (N1) der ersten 3-Level-Stromrichtereinrichtung (2) mit dem dritten Neutralspannungspotentialanschlusselement (N3) der zweiten 3-Level-Stromrichtereinrichtung (3) und
- das zweite Neutralspannungspotentialanschlusselement (N2) der ersten 3-Level-Stromrichtereinrichtung (2) mit dem vierten Neutralspannungspotentialanschlusselement (N4) der zweiten 3-Level-Stromrichtereinrichtung (3)
jeweilig über eine elektrisch leitfähige Klemme (13,13',17,17') verbunden ist.

9. 3-Level-Stromrichtersystem nach Anspruch 8, **dadurch gekennzeichnet, dass** die Klemme (13,13',17,17') ein erstes elektrisch leitendes Klemmelement (14) und ein zweites magnetisch nicht leitendes Klemmelement (15) zwischen denen die über die jeweilige Klemme (13,13',17,17') miteinander verbunden jeweiligen Potentialanschlusselemente (DC1+,DC2+,DC1-,DC2-,N1 ,N2,N3,N4) angeordnet sind, aufweist.

10. 3-Level-Stromrichtersystem nach Anspruch 7, **dadurch gekennzeichnet, dass**
- das erste Gleichspannungspositivpotentialanschlusselement (DC1+) der ersten 3-Level-Stromrichtereinrichtung (2) mit dem zweiten Gleichspannungspositivpotentialanschlusselement (DC2+) der zweiten 3-Level-Stromrichtereinrichtung (3) und
- das erste Gleichspannungsnegativpotentialanschlusselement (DC1-) der ersten 3-Level-Stromrichtereinrichtung (2) mit dem zweiten Gleichspannungsnegativpotentialanschlusselement (DC2-) der zweiten 3-Level-Stromrichtereinrichtung (2) und
- das erste Neutralspannungspotentialanschlusselement (N1) der ersten 3-Level-Stromrichtereinrichtung (2) mit dem dritten Neutralspannungspotentialanschlusselement (N3) der zweiten 3-Level-Stromrichtereinrichtung (3)
- und das zweite Neutralspannungspotentialanschlusselement (N2) der ersten 3-Level-Stromrichtereinrichtung (2) mit dem vierten Neutralspannungspotentialanschlusselement (N4) der zweiten 3-Level-Stromrichtereinrichtung (3)
einen elektrisch leitenden Kontakt aufweist und jeweilig mittels einer Schraubverbindung (20) verbunden ist.

## Claims

1. 3-Level power converter device having power semiconductor components (6), wherein the 3-level power converter device (2, 3, 4) has, for the purpose of making electrical contact, a first DC voltage positive potential connection element (DC1+), a first DC voltage negative potential connection element (DC1-) and a first and a second neutral voltage potential connection element (N1, N2), each of which has a flat shape, is arranged on a first side (A) of the 3-level power converter device (2, 3, 4) and protrudes from the 3-level power converter device (2, 3, 4) in a positive direction in a first spatial direction (X), wherein the first and second neutral voltage potential connection elements (N2, N2) are electrically conductively connected to one another, wherein the first DC voltage positive potential connection element (DC1+) and the first neutral voltage potential connection element (N1) form a first connection element pair (24), and the second neutral voltage potential connection element (N2) and the first DC voltage negative potential connection element (DC1-) form a second connection element pair (35), wherein the first and second connection element pairs (34, 35) are arranged in succession in a second spatial direction (Y), wherein the first DC voltage positive potential connection element (DC1+) and the first neutral voltage potential connection element (N1) are arranged above one another in a third spatial direction (Z), and the second neutral voltage potential connection element (N2) and the first DC voltage negative potential connection element (DC1-) are arranged above one another in the third spatial direction (Z) .

2. 3-Level power converter device according to Claim 1, **characterized in that** the first DC voltage positive potential connection element (DC1+) and the first DC voltage negative potential connection element (DC1-) and the first and second neutral voltage potential connection elements (N1, N2) run parallel to a plane defined by the first and second spatial directions (X, Y).

3. 3-Level power converter device according to either of the preceding claims, **characterized in that** the second neutral voltage potential connection element (N2) and the first DC voltage positive potential connection element (DC1+) are arranged in succession in the second spatial direction (Y), and the first DC voltage negative potential connection element (DC1-) and the first neutral voltage potential connection element (N1) are arranged in succession in the second spatial direction (Y).

4. 3-Level power converter device according to one of the preceding claims, **characterized in that** the 3-level power converter device (2, 3, 4) has, for the purpose of making electrical contact, a second DC voltage positive potential connection element (DC2+), a second DC voltage negative potential connection element (DC2-) and a third and a fourth neutral voltage potential connection element (N3, N4), each of which has a flat shape, is arranged on a second side (B) of the 3-level power converter device (2, 3, 4), which is opposite the first side (A), and protrudes from the 3-level power converter device (2, 3, 4) in a negative direction in the first spatial direction (X), wherein the first, second, third and fourth neutral voltage potential connection elements (N1, N2, N3, N4) are electrically conductively connected to one another, and the first and second DC voltage positive potential connection elements (DC1+, DC2+) are electrically conductively connected to one another, and the first and second DC voltage negative potential connection elements (DC1-, DC2-) are electrically conductively connected to one another, wherein the second DC voltage positive potential connection element (DC2+) and the third neutral voltage potential connection element (N3) form a third connection element pair (36), and the fourth neutral voltage potential connection element (N4) and the second DC voltage negative potential connection element (DC2-) form a fourth connection element pair (37), wherein the third and fourth connection element pairs (36, 37) are arranged in succession in the second spatial direction (Y), wherein the second DC voltage positive potential connection element (DC2+) and the third neutral voltage potential connection element (N3) are arranged above one another in the third spatial direction (Z), and the fourth neutral voltage potential connection element (N4) and the second DC voltage negative potential connection element (DC2-) are arranged above one another in the third spatial direction (Z).

5. 3-Level power converter device according to Claim 4, **characterized in that** the second DC voltage positive potential connection element (DC2+) and the second DC voltage negative potential connection element (DC2-) and the third and fourth neutral voltage potential connection elements (N3, N4) run parallel to a plane defined by the first and second spatial directions (X, Y).

6. 3-Level power converter device according to Claim 4 or 5, **characterized in that** the second DC voltage negative potential connection element (DC2-) and the third neutral voltage potential connection element (N3) are arranged in succession in the second spatial direction (Y), and the fourth neutral voltage potential connection element (N4) and the second DC voltage positive potential connection element (DC2+) are arranged in succession in the second spatial direction (Y).

7. 3-Level power converter system, wherein the 3-level power converter system (5) has a first and a second 3-level power converter device (2, 3) designed according to one of Claims 4 to 6, wherein
- the first DC voltage positive potential connection element (DC1+) of the first 3-level power converter device (2) is electrically conductively connected to the second DC voltage positive potential connection element (DC2+) of the second 3-level power converter device (3), and
- the first DC voltage negative potential connection element (DC1-) of the first 3-level power converter device (2) is electrically conductively connected to the second DC voltage negative potential connection element (DC2-) of the second 3-level power converter device (3), and
- the first neutral voltage potential connection element (N1) of the first 3-level power converter device (2) is electrically conductively connected to the third neutral voltage potential connection element (N3) of the second 3-level power converter device (3), and
- the second neutral voltage potential connection element (N2) of the first 3-level power converter device (2) is electrically conductively connected to the fourth neutral voltage potential connection element (N4) of the second 3-level power converter device (3).

8. 3-Level power converter system according to Claim 7, **characterized in that**
- the first DC voltage positive potential connection element (DC1+) of the first 3-level power converter device (2) is connected to the second DC voltage positive potential connection element (DC2+) of the second 3-level power converter device (3), and
- the first DC voltage negative potential connection element (DC1-) of the first 3-level power converter device (2) is connected to the second DC voltage negative potential connection element (DC2-) of the second 3-level power converter device (3), and
- the first neutral voltage potential connection element (N1) of the first 3-level power converter device (2) is connected to the third neutral voltage potential connection element (N3) of the second 3-level power converter device (3), and
- the second neutral voltage potential connection element (N2) of the first 3-level power converter device (2) is connected to the fourth neutral voltage potential connection element (N4) of the second 3-level power converter device (3),
via a respective electrically conductive terminal (13, 13', 17, 17').

9. 3-Level power converter system according to Claim 8, **characterized in that** the terminal (13, 13', 17, 17') has a first electrically conductive terminal element (14) and a second magnetically nonconductive terminal element (15), between which the respective potential connection elements (DC1+, DC2+, DC1-, DC2-, N1, N2, N3, N4) connected to one another via the respective terminal (13, 13', 17, 17') are arranged.

10. 3-Level power converter system according to Claim 7, **characterized in that**
- the first DC voltage positive potential connection element (DC1+) of the first 3-level power converter device (2) is in electrically conductive contact with the second DC voltage positive potential connection element (DC2+) of the second 3-level power converter device (3), and
- the first DC voltage negative potential connection element (DC1-) of the first 3-level power converter device (2) is in electrically conductive contact with the second DC voltage negative potential connection element (DC2-) of the second 3-level power converter device (2), and
- the first neutral voltage potential connection element (N1) of the first 3-level power converter device (2) is in electrically conductive contact with the third neutral voltage potential connection element (N3) of the second 3-level power converter device (3),
- and the second neutral voltage potential connection element (N2) of the first 3-level power converter device (2) is in electrically conductive contact with the fourth neutral voltage potential connection element (N4) of the second 3-level power converter device (3),
and they are connected by means of a respective screw joint (20).

## Revendications

1. Dispositif convertisseur de courant à 3 niveaux, comprenant des composants à semi-conducteur de puissance (6), pour assurer le contact électrique, le dispositif convertisseur de courant à 3 niveaux (2, 3, 4) comportant un premier élément de connexion sur tension continue à potentiel positif (DC1+), un premier élément de connexion sur tension continue à potentiel négatif (DC1-) et un premier et un deuxième éléments de connexion sur potentiel de tension neutre (N1, N2), qui présentent chacun une forme plate, étant placés sur un premier côté (A) du dispositif convertisseur de courant à 3 niveaux (2, 3, 4) et dans une première direction spatiale (X) débordant dans la direction positive hors du système convertisseur de courant à 3 niveaux (2, 3, 4), le premier et le deuxième élément de connexion sur potentiel de tension neutre (N2, N2) étant connectés l'un à l'autre de manière à conduire l'électricité, le premier élément de connexion sur tension continue à potentiel positif (DC1+) et le premier élément de connexion sur potentiel de tension neutre (N1) formant une première paire d'éléments de connexion (34), et le deuxième élément de connexion sur potentiel de tension neutre (N2) et le premier élément de connexion sur tension continue à potentiel négatif (DC1-) formant une deuxième paire d'éléments de connexion (35), la première et la deuxième paire d'éléments de connexion (34, 35) étant placées l'une derrière l'autre dans une deuxième direction spatiale (Y), le premier élément de connexion sur tension continue à potentiel positif (DC1+) et le premier élément de connexion sur potentiel de tension neutre (N1) étant superposés dans une troisième direction spatiale (Z) et le deuxième élément de connexion sur potentiel de tension neutre (N2) et le premier élément de connexion sur tension continue à potentiel négatif (DC1-) étant superposés dans la troisième direction spatiale (Z) .

2. Dispositif convertisseur de courant à 3 niveaux selon la revendication 1, **caractérisé en ce que** le premier élément de connexion sur tension continue à potentiel positif (DC1+) et le premier élément de connexion sur tension continue à potentiel négatif (DC1-) et le premier et le deuxième élément de connexion sur potentiel de tension neutre (N1, N2) s'écoulent à la parallèle d'un plan s'étendant à travers la première et la deuxième direction spatiales (X, Y) .

3. Dispositif convertisseur de courant à 3 niveaux selon l'une quelconque des revendications précédentes, **caractérisé en ce que** le deuxième élément de connexion sur potentiel de tension neutre (N2) et le premier élément de connexion sur tension continue à potentiel positif (DC1+) sont placés l'un derrière l'autre dans la deuxième direction spatiale (Y) et le premier élément de connexion sur tension continue à potentiel négatif (DC1-) et le premier élément de connexion sur potentiel de tension neutre (N1) sont placés l'un derrière l'autre dans la deuxième direction spatiale (Y).

4. Dispositif convertisseur de courant à 3 niveaux selon l'une quelconque des revendications précédentes, **caractérisé en ce que** pour assurer le contact électrique, le dispositif convertisseur de courant à 3 niveaux (2, 3, 4) comporte un deuxième élément de connexion sur tension continue à potentiel positif (DC2+), un deuxième élément de connexion sur tension continue à potentiel négatif (DC2-) et un troisième et un quatrième élément de connexion sur potentiel de tension neutre (N3, N4), qui présentent chacun une forme plate, qui sont placés sur un deuxième côté (B) du dispositif convertisseur de courant à 3 niveaux (2, 3, 4) placé au vis-à-vis du premier côté (A) et qui débordent dans la première direction spatiale (X) en direction négative hors du dispositif convertisseur de courant à 3 niveaux (2, 3, 4), les premier, deuxième, troisième et quatrième éléments de connexion sur potentiel de tension neutre (N1, N2, N3, N4) étant connectés les uns avec les autres de manière à conduire l'électricité, et le premier et le deuxième élément de connexion sur tension continue à potentiel positif (DC1+, DC2+) étant connectés l'un avec l'autre de manière à conduire l'électricité, et le premier et le deuxième élément de connexion sur tension continue à potentiel négatif (DC1-, DC2-) étant connectés l'un avec l'autre de manière à conduire l'électricité, le deuxième élément de connexion sur tension continue à potentiel positif (DC2+) et le troisième élément de connexion sur potentiel de tension neutre (N3) formant une troisième paire d'éléments de connexion (36), et le quatrième élément de connexion sur potentiel de tension neutre (N4) et le deuxième élément de connexion sur tension continue à potentiel négatif (DC2-) formant une quatrième paire d'éléments de connexion (37), la troisième et la quatrième paire d'éléments de connexion (36, 37) étant placées l'une derrière l'autre dans la deuxième direction spatiale (Y), le deuxième élément de connexion sur tension continue à potentiel positif (DC2+) et le troisième élément de connexion sur potentiel de tension neutre (N3) étant superposés dans la troisième direction spatiale (Z) et le quatrième élément de connexion sur potentiel de tension neutre (N4) et le deuxième élément de connexion sur tension continue à potentiel négatif (DC2-) étant superposés dans la troisième direction spatiale (Z).

5. Dispositif convertisseur de courant à 3 niveaux selon la revendication 4, **caractérisé en ce que** le deuxième élément de connexion sur tension continue à potentiel positif (DC2+) et le deuxième élément de connexion sur tension continue à potentiel négatif (DC2-) et le troisième et le quatrième élément de connexion sur potentiel de tension neutre (N3, N4) s'écoulent à la parallèle d'un plan s'étendant à travers la première et la deuxième direction spatiale (X, Y).

6. Dispositif convertisseur de courant à 3 niveaux selon la revendication 4 ou 5, **caractérisé en ce que** le deuxième élément de connexion sur tension continue à potentiel négatif (DC2-) et le troisième élément de connexion sur potentiel de tension neutre (N3) sont placés l'un derrière l'autre dans la deuxième direction spatiale (Y) et le quatrième élément de connexion sur potentiel de tension neutre (N4) et le deuxième élément de connexion sur tension continue à potentiel positif (DC2+) sont placés l'un derrière l'autre dans la deuxième direction spatiale (Y) .

7. Système convertisseur de courant à 3 niveaux, le système convertisseur de courant à 3 niveaux (5) comportant un premier et un deuxième dispositif convertisseur de courant à 3 niveaux (2, 3) conçus selon l'une quelconque des revendications 4 à 6, le premier élément de connexion sur tension continue à potentiel positif (DC1+) du premier dispositif convertisseur de courant à 3 niveaux (2) étant connecté de manière à conduire l'électricité avec le deuxième élément de connexion sur tension continue à potentiel positif (DC2+) du deuxième dispositif convertisseur de courant à 3 niveaux (3) et le premier élément de connexion sur tension continue à potentiel négatif (DC1-) du premier dispositif convertisseur de courant à 3 niveaux (2) étant connecté de manière à conduire l'électricité avec le deuxième élément de connexion sur tension continue à potentiel négatif (DC2-) du deuxième dispositif convertisseur de courant à 3 niveaux (3) et le premier élément de connexion sur potentiel de tension neutre (N1) du premier dispositif convertisseur de courant à 3 niveaux (2) étant connecté de manière à conduire l'électricité avec le troisième élément de connexion sur potentiel de tension neutre (N3) du deuxième dispositif convertisseur de courant à 3 niveaux (3) et le deuxième élément de connexion sur potentiel de tension neutre (N2) du premier dispositif convertisseur de courant à 3 niveaux (2) étant connecté de manière à conduire l'électricité avec le quatrième élément de connexion sur potentiel de tension neutre (N4) du deuxième dispositif convertisseur de courant à 3 niveaux (3).

8. Système convertisseur de courant à 3 niveaux selon la revendication 7, **caractérisé en ce que**
- le premier élément de connexion sur tension continue à potentiel positif (DC1+) du premier dispositif convertisseur de courant à 3 niveaux (2) avec le deuxième élément de connexion sur tension continue à potentiel positif (DC2+) du deuxième dispositif convertisseur de courant à 3 niveaux (3) et
- le premier élément de connexion sur tension continue à potentiel négatif (DC1-) du premier dispositif convertisseur de courant à 3 niveaux (2) avec le deuxième élément de connexion sur tension continue à potentiel négatif (DC2-) du deuxième dispositif convertisseur de courant à 3 niveaux (3) et
- le premier élément de connexion sur potentiel de tension neutre (N1) du premier dispositif convertisseur de courant à 3 niveaux (2) avec le troisième élément de connexion sur potentiel de tension neutre (N3) du deuxième dispositif convertisseur de courant à 3 niveaux (3) et
- le deuxième élément de connexion sur potentiel de tension neutre (N2) du premier dispositif convertisseur de courant à 3 niveaux (2) avec le quatrième élément de connexion sur potentiel de tension neutre (N4) du deuxième dispositif convertisseur de courant à 3 niveaux (3) sont connectés respectivement par l'intermédiaire d'une borne (13, 13', 17, 17') conductrice d'électricité.

9. Système convertisseur de courant à 3 niveaux selon la revendication 8, **caractérisé en ce que** la borne (13, 13', 17, 17') comporte un premier élément de serrage (14) conducteur d'électricité et un deuxième élément de serrage (15) non conducteur magnétique, entre lesquels sont placés les éléments de connexion de potentiel (DC1+, DC2+, DC1-, DC2-, N1, N2, N3, N4) respectifs, connectés les uns aux autres par l'intermédiaire de la borne (13, 13', 17, 17') respective.

10. Système convertisseur de courant à 3 niveaux selon la revendication 7, **caractérisé en ce que**
- le premier élément de connexion sur tension continue à potentiel positif (DC1+) du premier dispositif convertisseur de courant à 3 niveaux (2) comporte un contact conducteur d'électricité avec le deuxième élément de connexion sur tension continue à potentiel positif (DC2+) du deuxième dispositif convertisseur de courant à 3 niveaux (3) et
- le premier élément de connexion sur tension continue à potentiel négatif (DC1-) du premier dispositif convertisseur de courant à 3 niveaux (2) comporte un contact conducteur d'électricité avec le deuxième élément de connexion sur tension continue à potentiel négatif (DC2-) du deuxième dispositif convertisseur de courant à 3 niveaux (2) et
- le premier élément de connexion sur potentiel de tension neutre (N1) du premier dispositif convertisseur de courant à 3 niveaux (2) comporte un contact conducteur d'électricité avec le troisième élément de connexion sur potentiel de tension neutre (N3) du deuxième dispositif convertisseur de courant à 3 niveaux (3)
- et le deuxième élément de connexion sur potentiel de tension neutre (N2) du premier dispositif convertisseur de courant à 3 niveaux (2) comporte un contact conducteur d'électricité avec le quatrième élément de connexion sur potentiel de tension neutre (N4) du deuxième dispositif convertisseur de courant à 3 niveaux (3)
et tous ces éléments sont respectivement connectés par un assemblage par vis (20).
